# EUROPEAN PATENT APPLICATION

(11) **EP 0 925 860 A2**
(43) Date of publication of application: **30.06.1999**
(21) Application number: 98310452.2
(22) Date of filing: 18.12.1998
(51) Int. Cl.: B22F 9/28, B22F 1/00, H01M 4/80

(54) **Nickel ultrafine powder**

(30) Priority: 25.12.1997 JP 35776497
(71) Applicant: Kawatetsu Mining Co., LTD., Tokyo 111-0051 (JP)
(72) Inventor: Katayama, Hideshi, c/o Kawatetsu Mining Co., Ltd., Tokyo 111-0051 (JP); Saito, Kan, c/o Kawatetsu Mining Co., Ltd., Tokyo 111-0051 (JP)
(74) Representative: Atkinson, Jonathan David Mark

(57) **Abstract**

A nickel ultrafine powder having an average particle diameter of 0.1 to 1.0 µm and containing silicon in an amount of 0.5 to 5.0 wt%, with the remainder being substantially nickel. It is produced from nickel chloride vapor and silicon chloride vapor by reduction with hydrogen in the gas phase. It gives thin low-resistance internal electrodes of laminated ceramic capacitors. It contributes to reduction of percent defective due to cracking and delamination.

## Description

### BACKGROUND OF THE INVENTION

### 1. Field of the Invention:

The present invention relates to a nickel ultrafine powder to be used for internal electrodes of multilayered ceramic capacitors or electrodes of secondary batteries, fuel cells or the like.

### 2. Description of the Related Art:

Nickel ultrafine powder is attracting attention as a material to form internal electrodes of laminated ceramic capacitors, porous electrodes of hydrogen-nickel secondary batteries, hollow porous electrodes for fuel cells (which provide electric energy through electrochemical oxidation of fuel), and electrodes of a variety of electric parts.

The following description is concentrated on internal electrodes of laminated ceramic capacitors.

A laminated ceramic capacitor is composed of layers of ceramic dielectric (such as titanium oxide, barium titanate, and complex perovskite) and layers of metal internal electrodes which are laminated alternately under pressure and integrally fired. Today, it finds rapidly increasing use as an electronic part. It is decreasing in size and increasing in capacity, with its internal electrodes becoming thinner, to meet demand for electronic machines and equipment of higher performance. It is conventionally provided with palladium internal electrodes, but they are being replaced recently by nickel internal electrodes which are comparatively inexpensive and yet highly reliable.

Japanese Patent Laid-open No. 136910/1989 discloses a technique for producing by wet process a nickel powder having a purity higher than 99% and a particle diameter of 0.1-0.3 µm. However, it does not mention actually making the powder into paste and electrodes for electronic parts. The present inventors found that conventional nickel powder made by wet process suffers the disadvantage of greatly changing in volume at the time of firing, causing continual delamination and/or cracking to the laminate. A conceivable reason for this is that the wet process proceeds at too low a temperature (e.g., lower than 100°C) for sufficient crystal growth, giving rise to agglomeration with fine primary particles, which are liable to over-sintering or marked volume change during firing.

Japanese Patent Laid-open No. 80007/1989 discloses a nickel powder having an average particle diameter of 1.0 µm and a purity of 99.9% which is to be used as paste for electrodes of ceramic capacitors. This paste is incorporated with carbide powder to prevent cracking and/or delamination at the time of firing. However, nothing is mentioned about the characteristics of the nickel powder itself which affect cracking and/or delamination.

Japanese Patent Laid-open No. 246001/1996 discloses a nickel ultrafine powder having an average particle diameter of 0.1-1.0 µm and a purity higher than 99.5 wt%, which is used for laminated ceramic capacitors. It mentions nothing about the content of other components than nickel.

Production of laminated ceramic capacitors needs techniques for preventing cracking and/or delamination at the time of firing, making internal electrodes thinner, and providing capacitors smaller in size and higher in capacity. This has aroused a demand for developments of nickel ultrafine powder which will simplify the production of laminated ceramic capacitors and reduce the percent defective affecting the production cost.

### SUMMARY OF THE INVENTION

It is an object of the present invention, which was completed to address the above-mentioned problems involved in conventional technologies, to provide an improved nickel ultrafine powder, more particularly, to provide a nickel ultrafine powder which, when used as an electrode material, permits laminated ceramic capacitors to be produced in a simpler manner, weakens the tendency toward cracking and delamination, gives thinner internal electrodes, and helps one to reduce the percent defective of laminated ceramic capacitors.

The nickel ultrafine powder according to the present invention is characterized by an average particle diameter of 0.1-1.0 µm and a silicon content of 0.5-5.0 wt%, with the remainder being substantially nickel.

The nickel ultrafine powder mentioned above should preferably be one which is produced from nickel chloride vapor and silicon chloride vapor by reduction with hydrogen in the gas phase. It will be used for porous electrodes in nickel-hydrogen batteries and hollow porous electrode in fuel cells. It is particularly suitable for use as electrodes in laminated ceramic capacitors because the resulting electrodes are less liable to cracking and/or delamination, can be made thinner, and have a lower resistance.

The nickel ultrafine powder of the present invention should have an average particle diameter of 0.1-1.0 µm as specified above for the reasons given below. This fineness is necessary for it to give a paste which, when applied to insulating layers by printing, forms thin compact internal electrodes. With an average particle diameter smaller than 0.1 µm, it gives rise to a nickel layer which, when laminated ceramic capacitors are fired, shrinks due to sintering, resulting in porous internal electrodes which are high in electric resistance and liable to cracking and/or delamination. With an average particle diameter larger than 1.0 µm, it will present difficulties in forming thin internal electrodes but it will give internal electrodes with marked surface irregularities, which lead to cracking. A preferred average particle diameter ranges from 0.2 to 0.6 µm. Incidentally, the average particle diameter is expressed in terms of 50% particle diameter (d₅₀) of the number-size distribution obtained by analyzing electron micrographs.

The nickel ultrafine powder for laminated ceramic capacitors depends for its characteristics on its particle size as well as its sintering temperature. A laminated ceramic capacitor is composed of dielectric layers and internal electrode layers of nickel ultrafine powder. The dielectric layers are usually made of barium titanate having a comparatively high sintering temperature, whereas the nickel ultrafine powder is comparatively low in sintering temperature. It is desirable that the dielectric layer and the internal electrode layer have sintering temperatures close to each other.

The nickel ultrafine powder of the present invention should contain silicon in an amount of 0.5-5 wt% on the basis of the present inventor's finding that nickel markedly increases in sintering temperature when alloyed with silicon. The effect of silicon on sintering temperature is noticeable when the silicon content is 0.5-5.0 wt%. In other words, the nickel ultrafine powder containing 0.5-5.0 wt% silicon has a high sintering temperature as desired.

With this silicon content, the nickel ultrafine powder has an adequate sintering temperature which is close to that of the dielectric. Thus the resulting laminated ceramic capacitors can be sintered at an adequate temperature without internal cracking and delamination.

Inclusion of silicon into nickel ultrafine powder can be accomplished by reacting either or both of silicon and silicon compound with nickel chloride vapor alone or carried by an inert gas or hydrogen gas.

The nickel ultrafine powder having an average particle diameter and a silicon content as specified above can be readily produced from nickel chloride vapor and silicon chloride vapor (in a controlled amount) by reduction with hydrogen in the gas phase. This reaction can be accomplished by using a reactor consisting of an evaporator, a reaction chamber, and a cooling unit. The evaporator contains crucibles. The reaction chamber receives nickel chloride vapor and silicon chloride vapor carried by an inert gas from the evaporator, which are reacted therein with hydrogen gas at a prescribed temperature. The cooling unit receives a reaction gas containing nickel ultrafine powder from the reaction chamber.

The nickel ultrafine powder produced in this manner is characterized by a higher sintering temperature, a spherical particle shape, a uniform particle size, and a sharp particle size distribution. Moreover, the powder consists of nickel single particles instead of agglomerates.

### BRIEF DESCRIPTION OF THE DRAWINGS

Fig. 1 is a graph showing the percent defective of laminated ceramic capacitors produced from nickel ultrafine powder having an average particle diameter of 0.11 µm.

Fig. 2 is a graph showing the percent defective of laminated ceramic capacitors produced from nickel ultrafine powder having an average particle diameter of 0.45 µm.

Fig. 3 is a graph showing the percent defective of laminated ceramic capacitors produced from nickel ultrafine powder having an average particle diameter of 1.02 µm.

### DESCRIPTION OF THE PREFERRED EMBODIMENTS

Results of experiments on the production of laminated ceramic capacitors from various kinds of nickel ultrafine powder revealed that the average particle diameter and silicon content are the most important characteristic properties required of nickel ultrafine powder to be made into thin, low-resistance internal electrodes by firing at a comparatively high temperature without cracking and/or delamination.

The average particle diameter should be in the range of 0.1 to 1.0 µm. A nickel powder having an average particle diameter smaller than 0.1 µm gives a nickel layer which shrinks due to sintering when laminated ceramic capacitors are fired, and hence the resulting internal electrodes are porous and high in electric resistance and are liable to cracking and/or delamination. On the other hand, a nickel powder having an average particle diameter larger than 1.0 µm gives internal electrodes which are thick and irregular in surface and hence are liable to cracking.

For the same reasons as mentioned above, the average particle diameter should preferably be in the range of 0.2-0.6 µm. The average particle diameter is expressed in terms of 50% particle diameter (d₅₀) of the number-size distribution obtained by analyzing electron micrographs.

The nickel ultrafine powder produces good results when it is sintered at as high a temperature as possible. It varies in sintering temperature depending on the amount of silicon it contains. Silicon forms thin silicon oxide film on nickel particles, thereby limiting sintering between nickel particles. This results in a higher sintering temperature.

Thus the nickel ultrafine powder has a higher sintering temperature as desired only if it has an average particle diameter of 0.1 to 1.0 µm and contains silicon in an amount of 0.5 to 5.0 wt%.

The present invention will be described in more detail with reference to the following examples.

Samples of laminated ceramic capacitors were prepared with any one of nickel ultrafine powder specified in Examples 1 to 3, and they were examined for delamination due to firing. Those which suffered delamination are regarded as defective. The nickel ultrafine powder in the form of paste was applied by printing onto an approximately 3 µm thick green sheet of dielectric to form a 2 µm thick electrode. Two hundred layers of electrodes and green sheets were laminated on top of the other. The resulting laminate was pressed, cut in size, dried, and excluded of binder. Finally, it was fired at 1150-1250°C in a mixed gas of hydrogen, nitrogen, and water vapor. The thus obtained laminated ceramic capacitor measured 3.2 mm long, 1.6 mm wide, and 1.6 mm thick.

### Example 1

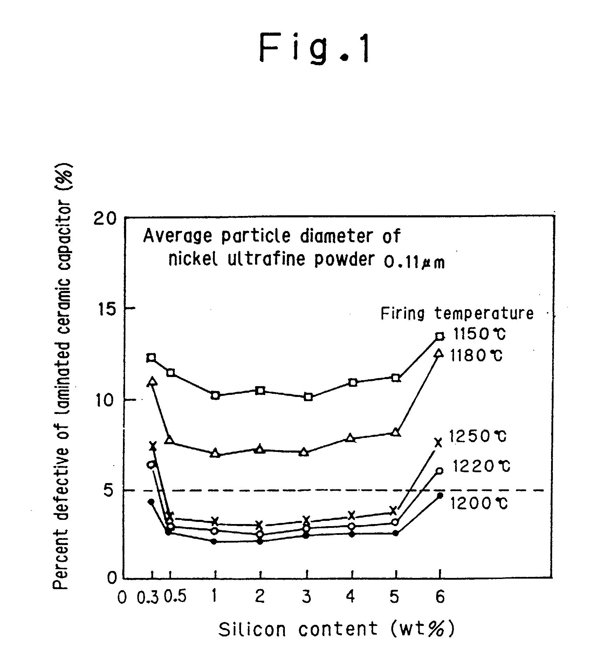

Samples of nickel ultrafine powder were prepared which have an average particle diameter of 0.11 µm and contain silicon in an amount ranging from 0.3 to 6.0 wt%. They were used to make laminated ceramic capacitors which were fired at a temperature ranging from 1150 to 1250°C. The resulting ceramic capacitors were examined for percent defective. The results are shown in Fig. 1. It is noted that the percent defective is lower than 5% if the silicon content is 0.5-5.0 wt% and the firing temperature is 1200-1250°C. By contrast, the percent defective is higher than 5% regardless of the silicon content if the firing temperature is 1150°C or 1180°C. It is apparent from Fig. 1 that the percent defective is low at the adequate firing temperature if the silicon content is 0.5-5.0 wt%. Incidentally, the percent defective exceeds 5% if the silicon content is 0.3 wt% or 6.0 wt% regardless of firing temperature, except for 1200°C.

### Example 2

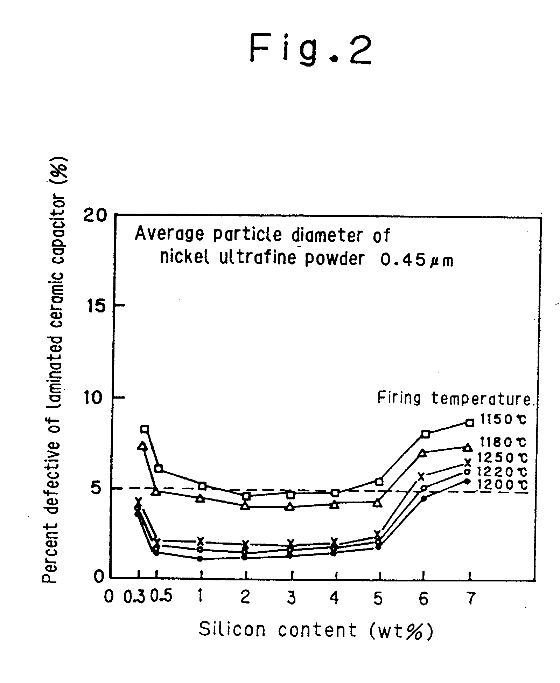

Samples of nickel ultrafine powder were prepared which have an average particle diameter of 0.45 µm and contain silicon in an amount ranging from 0.3 to 7.0 wt%. They were used to make laminated ceramic capacitors which were fired at a temperature ranging from 1150 to 1250°C. The resulting ceramic capacitors were examined for percent defective. The results are shown in Fig. 2. It is noted that the percent defective is lower than 5% if the silicon content is 0.5-5.0 wt% and the firing temperature is 1180-1250°C. It is noted that the percent defective is lower than 5% if the silicon content is 0.3 wt% and the firing temperature is 1200-1250°C. By contrast, the percent defective is higher than 5% if the firing temperature is 1150°C or 1180°C. If the silicon content is 6.0 wt%, the percent defective is lower than 5% only when the firing temperature is 1200°C. If the silicon content is 7.0 wt%, the percent defective is higher than 5% regardless of the firing temperature. Thus the percent defective is low only if the silicon content is in the range of 0.5-5.0 wt%.

### Example 3

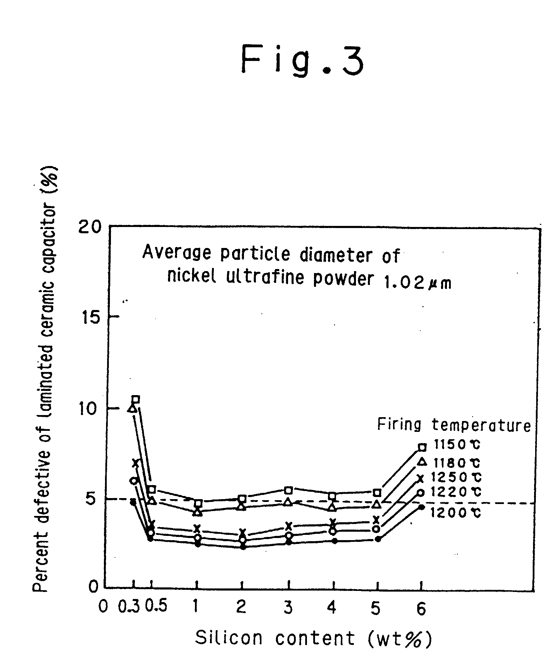

Samples of nickel ultrafine powder were prepared which have an average particle diameter of 1.02 µm and contain silicon in an amount ranging from 0.3 to 6.0 wt%. They were used to make laminated ceramic capacitors which were fired at a temperature ranging from 1150 to 1250°C. The resulting ceramic capacitors were examined for percent defective. The results are shown in Fig. 3. It is noted that the percent defective is lower than 5% if the silicon content is 0.5-5.0 wt% and the firing temperature is 1180-1250°C. If the silicon content is 0.3 wt% or 6.0 wt%, the percent defective is lower than 5% only when the firing temperature is 1200°C. Thus the percent defective is low only if the silicon content is in the range of 0.5-5.0 wt%.

As shown in Examples above, when the nickel ultrafine powder of the present invention is used, the percent defective of laminated ceramic capacitors is low.

It has been demonstrated above that it is possible to raise the sintering temperature for laminated ceramic capacitors only when they are made with a nickel ultrafine powder having an average particle diameter ranging from 0.1 to 1.0 µm and containing silicon in an amount ranging from 0.5 to 5.0 wt%.

The nickel ultrafine powder has been explained above on the assumption that it will be used mainly for the internal electrodes of laminated ceramic capacitors; however, it will also find use as electrode materials of secondary batteries and fuel cells.

The effect of silicon mentioned above can be obtained also from aluminum or the like which easily alloys with nickel and easily oxidizes to form compact oxide ceramics.

The nickel ultrafine powder of the present invention gives thin low-resistance internal electrodes of laminated ceramic capacitors. It can be fired at the same high temperature as ceramics, with the percent defective due to firing decreased.

## Claims

1. A nickel ultrafine powder which is characterized by having an average particle diameter of 0.1 to 1.0 µm and containing silicon in an amount of 0.5 to 5.0 wt%, with the remainder being substantially nickel.

2. A nickel ultrafine powder as defined in claim 1 which is produced from nickel chloride vapor and silicon chloride vapor by reduction with hydrogen in the gas phase.

3. A nickel ultrafine powder as defined in claim 1 which is used for laminated ceramic capacitors.

4. A nickel ultrafine powder as defined in claim 2 which is used for laminated ceramic capacitors.
